# EUROPEAN PATENT SPECIFICATION

(11) **EP 2 702 189 B1**
(45) Date of publication and mention of the grant of the patent: **07.03.2018**
(21) Application number: 12716430.9
(22) Date of filing: 25.04.2012
(51) Int. Cl.: C25D 3/38, C25D 5/02, C25D 7/12

(54) **AQUEOUS ACIDIC BATH FOR ELECTROLYTIC DEPOSITION OF COPPER**
WÄSSRIGES SÄUREBAD ZUR ELEKTROLYTISCHEN ABLAGERUNG VON KUPFER
BAIN AQUEUX ACIDE POUR LE DÉPÔT ÉLECTROLYTIQUE DE CUIVRE

(30) Priority: 26.04.2011 EP 11163752
(43) Date of publication of application: 05.03.2014
(73) Proprietor: Atotech Deutschland GmbH, 10553 Berlin (DE)
(72) Inventor: DAMBROWSKY, Nina, 10405 Berlin (DE); HAUF, Uwe, 90530 Wendelstein (DE); EWERT, Ingo, 14167 Berlin (DE); DAMBROWSKY, Christof, 10405 Berlin (DE); WENZEL, René, 12167 Berlin (DE)
(74) Representative: Patentanwälte Bressel und Partner mbB
(86) International application number: PCT/EP2012/057504
(87) International publication number: WO 2012/146591

(56) References cited:
- WO-A1-2010/094998
- US-A- 3 530 049
- US-A- 6 129 830
- US-A1- 2004 041 264
- US-A1- 2005 014 014
- IGOR VOLOV ET AL: "Investigation of Copper Plating and Additive Interactions in the Presence of Fe3+/Fe2+ Redox Couple", JOURNAL OF THE ELECTROCHEMICAL SOCIETY, vol. 158, no. 6, 15 April 2011 (2011-04-15), pages D384-D389, XP055002754, ISSN: 0013-4651, DOI: 10.1149/1.3575638

## Description

The invention relates to an aqueous, acid bath and to a process for the electrolytic deposition of copper, in particular for filling blind micro vias, through hole vias, trenches and similar structures on printed circuit boards, chip carriers and semiconductor wafers, or for plating surfaces.

Adding numerous different organic additives to acid electrolytic copper baths is known in order to enable the decorative and functional characteristics of the copper coatings to be controlled. Above all, brighteners and carriers are added to the baths in order to obtain ductile, regular and bright deposits. In addition, organic compounds are used as additives to the copper electrolytes during the production of printed circuit boards, chip carriers and semiconductor wafers, and these compounds are to act as suppressors and accelerators and enable a uniform a deposition of copper as possible in and on different regions of the surface of the printed circuit board or of the structure of the printed circuit board, e.g., the trenches, through hole vias or BMVs.

The uniform metal deposition in structures such as trenches, blind micro vias (BMVs) or through hole vias (via = Vertical Interconnect Access) with copper is often difficult: Because of the geometric arrangement and development of these structures, they exhibit a variable electric depositing behavior. In particular, in very small structures of this type, influences of the diffusion of the metal ions and of the additives towards the deposition location are dominant. A uniform filling with copper is the prerequisite for the development of complex conductor structures. An insufficient or non-uniform filling, often leads to their uselessness and consequently to the rejection of the entire printed circuit board or chip carrier.

Moreover, insufficient and non-uniform metallization of trenches, through hole vias and BMVs on printed circuit boards, chip carriers and wafers can lead to formation of hollow spaces (voids) or inclusions of undesired substances in the copper deposit. An insufficient and non-uniform metallisation of the structures may also have the effect that the structures are be reproduced on the surface after a electroplating of copper. This makes additional operating steps and material costs necessary for building up subsequent layers and problems can arise due to impedance fluctuations that are no longer tolerable.

With the progressive miniaturisation of printed circuit boards or the design of printed circuit boards and wafers becoming ever more complex, with the aim, among other things, of providing greater calculating capacities and/or functionalities in an ever decreasing space, the industry is always facing new challenges. At the same time, the geometry, for example of the printed circuit boards or respectively of the conductor path structures and of the conductor structures on printed circuit boards, chip carriers and semiconductor wafers is becoming more and more complicated.

In view of the above there is the demand that filling of trenches, through hole vias and BMVs on printed circuit boards, chip carriers and semiconductor wafers should be as complete and uniform as possible in order to guarantee reliable generation of the conductor structures.

Several deposition bath compositions have been disclosed in the prior art in order to meet these requirements

P.M. Vereecken et al."The chemistry of additives in damascene copper plating", IBM J. Res. & Dev., Vol. 49 (Jan. 2005), No. 1 , 3-18, describes compositions containing, for example, polyether, sulfur-based organic compounds and levelers, such as thiourea, benzotriazole (BTA) and Janus Green B (JGB), with which mirror-like copper surfaces can be generated and which enable accelerated copper deposition in the finest trenches.

US patent No. 2,876,178 describes an alkaline cyanide copper bath in which amino acids or secondary amino acid derivatives, such as peptones and peptides, are contained. These additives are said to have advantageous effects on the copper depositing process.

US 2002/0195351 A1 discloses a composition for the electrolytic deposition of copper onto integrated circuits, for example in narrow trenches for conductor paths or conductor path connections (vias). The composition contains, along with other additives, sulfur containing amino acids as polishing means, for example, cysteine, percysteine, glutathione and the derivatives and salts thereof.

US 5,972,192 discloses a method of electroplating Cu to reliably fill openings in a dielectric layer, particularly high aspect ratio openings for contacts, vias and/or trenches. An electroplating solution is employed which comprises a leveling agent and optionally a brightening agent. The leveling agent can be selected from polyethyleneimine, polygylcine, 2-amino-1-naphthalinesulfonic acid, 3-amino-1-propanesulfonic acid, 4- aminotoluene-2-sulfonic acid and further compounds. A suitable brightening agent may be 2,5-dimercapto-1 ,3,4-thiodiazol.

WO2009132861 relates to the problem to generate a very uniform copper deposit in particular in blind micro vias (BMVs) and trenches, and discloses an aqueous, acid bath for the electrolytic deposition of copper, said bath containing at least one copper ion source, at least one acid ion source, at least one brightener compound and at least one leveler compound, wherein at least one leveler compound is selected from the group comprising synthetically produced non-functionalized peptides and synthetically produced functionalized peptides and synthetically produced functionalized amino acids.

US 6129830A relates to the problem of finding a process for depositing copper layers as uniformly thick as possible at all sites of the coated surface and have sufficiently favorable visual and mechanical properties. A process comprises following process steps:
a) Preparing a deposition bath containing copper ions, at least one compound that increases the electrical conductivity of the deposition bath, at least one additive to influence the material properties of the copper layers, at least one additional compound of an electrochemically reversible redox system, and a solvent or solvent mixture,
b) Bringing an electrically-conductive substrate and at least one anode that disintegrates upon electrolytic deposition into contact with the deposition bath,
c) Connecting the substrate and the anode to a power supply, and depositing the copper layers on the substrate using a pulsed current or pulsed voltage process. Ruthenium in slight amounts may be used as the redox system.

There is, however, still a need for improving previously known bath solutions in order to achieve an even more uniform filling of structures as through holes, trenches and BMVs with copper. There is a need to reach a filling of micro structures of through holes, trenches and BMVs with even more precision in a more uniform manner, i.e., with a copper surface that is as even and thin as possible.

Consequently, it is one object of the present invention to solve this problem and, over and above this, to guarantee that the aforementioned requirements are constantly achievable even under the conditions of mass production. In particular, micro structures, such as through holes, trenches and BMVs, on printed circuit boards, chip carriers and semiconductor wafers, are to be filled in such a manner that there are no disadvantageous effects, such dimples or recesses, and inclusions and that an even surface is produced overall.

An object of the present invention was also to provide a beneficial process for filling micro structures, such as through holes, trenches and BMVs.

WO2006032346 discloses a two step process for filling through-hole vias. In the first step of said process deposition occurs in the center of the through-holes. Thereby, the hole center is filled, and two blind holes, i.e. blind micro vias, are formed which are each closed at one end close to the hole center. In a second metallization step the thus created blind holes are filled with metal. WO2006032346 suggests using a bath containing copper sulfate, sulfuric acid, chloride, iron ions, a sulfur-containing compound as a brightening agent and a leveling agent, which can be a polymeric nitrogen compound, a nitrogen containing sulfur compound or a polymeric phenazonium derivative. Moreover this publication suggests using different electrolytes in each step of the process and using different parameter for current flow in each step of the process, e.g. a pulse reverse current with different parameters for each step. For these reasons, the process of WO2006032346 is relatively complex. Moreover, said process, especially if used in a vertical metallization process, requires relatively long times before a through-hole is completely filled. Thus, an object of the present invention was to overcome these disadvantages.

The present invention provides with an aqueous acidic bath for electrolytic deposition of copper, comprising
- at least one source of copper ions,
- at least one acid,
- at least one brightener compound,
- at least one source of halide ions, and
- at least one substance that serves as a leveler for copper-deposition, wherein said at least one substance is dissolved ruthenium, and
- at least one source of iron ions as leveler and/or inhibitor for copper-deposition,
wherein iron is present in such amount that the molar ratio of iron/ruthenium is at least 1.5 Mol (Fe)/1 Mol (Ru)..

The present invention also provides with a process for electrolytic deposition of copper on a substrate which is described later in this application.

By the aqueous acidic bath and the process of the invention, including advantageous embodiments, the above mentioned objects are achieved partially or even completely.

The aqueous, acid bath according to the invention and the process according to the invention are preferably used for the electrolytic coating of objects, as printed circuit boards, chip carriers and semiconductor wafers, but also of any other circuit carriers and interconnect devices. The bath and process are used in particular in semiconductor wafers, printed circuit boards and chip carriers, to fill trenches, blind micro vias, through hole vias (through holes) and similar structures with copper.

By definition, a "through hole via" is a hole that goes all the way through an object, i.e. penetrates the object, particularly a wafer, a printed circuit board or a chip carrier. Preferably, a "through hole via" is a laser drilled hole or a mechanical drilled hole. Preferably a through hole via interconnects two external conducting layers of the object, and may optionally interconnect the external layers with one or more internal conducting layers. Through hole vias may have a sputtered or electroless deposited copper layer, which can be built up by conformal plating or be filled with copper or other metals.

By definition, a "blind micro via" is a copper plated hole that does not go all the way through an object, i.e. it does not penetrate the object. In other words, a blind micro via is a hole that ends inside of an object, particularly a wafer, a printed circuit board or a chip carrier. A blind micro via preferably connects one external conducting layer of the object with one or more internal conducting layers.

For explanation of through hole vias and blind micro vias it is also referred to R.S. Khhandpur, "Printed circuit boards, Design, Fabrication and Assembly", McGraw Hill, 2006, ISBN 0-07-146420-4, pages 185-186.

Particularly, the aqueous acidic bath of the invention or the process of the invention can be used for deposition of copper in trenches, blind-micro-vias, through-hole-vias, and comparable structures in printed circuit boards, chips, carriers, wafers and various other interconnect devices. The term "through hole vias" or "through holes", as used in the present invention, encompasses all kinds of through hole vias and includes so-called "through silicon vias" in silicon wafers.

Copper can be deposited in said structures. It has been shown that addition of ruthenium to an aqueous acidic bath for electrolytic deposition of copper improves uniform deposition of copper, particularly in blind-micro-vias (BMVs) and trenches. Ruthenium fulfills the function as a leveler for copper deposition. It is presumed that ruthenium is not deposited in said structures or built in deposited copper, but this presumption is not to be construed to be a limitation of the scope of the invention.

The term "leveler for copper-deposition" relates particularly to copper deposition in structures, particularly indentations, openings, recesses, and cavities, such as trenches, blind-micro-vias, through-hole-vias, and comparable structures. It relates to structures that are filled, or shall be filled, completely or partially, with copper.

The leveling function and the term "leveler" means the following: Using the aqueous, acid bath according to the invention and the method according to the invention, it is possible to deposit copper in a very uniform manner in the structures that are to be filled, as recessions and depressions, particularly trenches and BMVs. In particular it is possible to fill recessions and depressions totally, reduce a deposition of copper on the surface compared to deposition in the depressions/recessions, and to avoid or at least minimize any voids or dimples. This guarantees that an extensively smooth, even copper surface is formed that exhibits practically no deformations. For example, dimples are hardly ever to be seen in the area of BMVs, such that an ideal or almost ideal rectangular shape is produced in the cross-section of the conductor structure.

In another aspect ruthenium fulfills the function as a promoter for copper deposition. The function as a promoter for copper deposition means that structures, like through holes, BMVs and trenches, but particularly through holes, are filled in a shorter time with a deposition bath of the invention than with a bath not containing any ruthenium. This effect can also be seen in a partial filling process of through holes which is explained below in connection with the process of the invention.

It has been shown that the addition of ruthenium results in less copper deposition on the surface that surrounds the structures that are to be filled with copper. The surface surrounding a structure is the surface adjacent to the structure that is to be filled, e.g. the surface on a printed circuit board or wafer which is adjacent to a trench, BMV or through via (not the surface of the structure itself) Copper deposition on adjacent surfaces, as defined above, is reduced by ruthenium, which is a highly desired effect since copper deposition shall be focused on the structures to be filled. Thus, ruthenium promotes and levels copper deposition within the structures that are filled with copper, like through holes, BMVs and trenches, and, at the same time, inhibits copper deposition on surfaces adjacent to said structures where copper deposition is not desired. With respect to reduced copper deposition on surfaces adjacent to structures that are filled with copper, ruthenium can also be defined as an "inhibitor".

Besides ruthenium, the bath of the invention can comprise further substances that are known as levelers. Examples are Inpulse H5, Cuprapulse XP7 and Cuprapulse S4, products from Atotech. Ruthernium ions are used as promoter for copper deposition in microstructures selected from through holes, BMVs and trenches, and the use of ruthenium ions as leveler for copper deposition in microstructures, particularly through holes, blind micro vias or trenches. Practical uses are, without limitation, the use of ruthenium for above mentioned purpose, or to reach above-mentioned effects, singly or in combination, in aqueous acidic baths for electrolytic deposition of copper. Copper deposition can relate to deposition on printed circuit boards, chips, carriers, wafers and various other interconnect devices.

The bath comprises ruthenium in any dissolved state. Thus, the bath comprises dissolved ruthenium. Examples are dissolved ruthenium ions or a dissolved, inorganic or organic, ruthenium-compound, wherein the compound may be dissociated, or not dissociated, or not completely dissociated in the bath. Preferable concentration ranges of ruthenium in an aqueous acidic bath of the invention, which means dissolved ruthenium, are 0.01 mg/l - 100 mg/l, or 0.1 mg/l - 100 mg/l, or 0.5 mg/l - 100 mg/l, or 0.01 mg/l - 80 mg/l, or 0.1 mg/l - 80 mg/l, or 0.5 mg/l - 80 mg/l, or 0.01 mg/l - 50 mg/l, or 0.1 mg/l - 50 mg/l, or 0.5 mg/l - 50 mg/l. A concentration of more than 100 mg/l may lead to the formation of voids. The concentrations are related to the mass of ruthenium atoms per bath volume, not to the mass of any ruthenium compound that is added to the bath-composition.

For example, ruthenium may be added as a completely or partially water soluble ruthenium compound. The ruthenium compound may be an inorganic or a (metal) organic compound. Moreover, the ruthenium compound may be an ionic or a nonionic compound. Examples are, without limitation, ruthenium salts, ruthenium complex compounds, or another inorganic or organic compounds containing ruthenium. The aqueous acidic bath of the invention may, for example, contain dissolved ruthenium ions, or a dissolved ruthenium compound, for example a dissolved ruthenium complex or another dissolved organic or inorganic compound containing ruthenium. Examples of ruthenium salts are ruthenium chloride, particularly
ruthenium(3.5)chloride. Also suitable are acetates, carbonates, acetates, bromides, carbonates, fluorides, sulfates, tetrafluorborates, phosphates, perchlorates, citrates, fumarates, gluconates, methansulfonates and oxalates of ruthenium. Examples of ruthenium complexes are ruthenium complexes with ruthenium in different oxidation states with ligands like bipyridine, salen, phenanthroline, sulfonic acids etc. Particularly ligands with donor atoms like C, N, O, S, P, Se etc. are suitable to build complexes which can be used as additives.

Different oxidation states of ruthenium may be used. Preferably, ruthenium is used in the oxidation states Ru(II) and/or Ru(III), wherein other oxidation states, as for example Ru(IV) and higher, may be present in minor amounts. In this embodiment, ruthenium is predominantly present as Ru(II) or Ru(III), or as a mixture of both. In this sense, Ruthenium is present in an average oxidation state in the range of II to III, wherein this range includes oxidation states II and III. Thus, ruthenium that is preferably present may be defined as Ru(II-III). The average oxidation state means the averaged oxidation state of all Ru-ions present in the bath. It has been found that Ru(II-III) has improved solubility in the bath of the invention, in comparison to higher oxidation states. Improved solubility of Ru leads to the result that beneficial functions of Ru, as described in this description, for example leveling effect, promoting effect etc, are even better fulfilled. Moreover, it has been found out that in such oxidation state the bath shows a desirable yellow or green or green/yellow-color, whereas in higher oxidation states the bath shows brown to dark brown color which is a drawback in its application. Ru(II-III) oxidation state is reached by adding iron in molar excess with respect to ruthenium, wherein iron is present in such amount that the molar ratio of iron/ruthenium is at least 1.5 Mol (Fe)/1 Mol (Ru). Preferable molar ratios of iron to ruthenium are: at least 2.0 Mol(Fe)/1 Mol(Ru), or at least 3.0 Mol(Fe)/1 Mol(Ru), or at least 4.0 Mol(Fe)/1 Mol(Ru), or at least 5.0 Mol(Fe)/1 Mol(Ru), or at least 6.0 Mol(Fe)/1 Mol(Ru), or at least 8.0 Mol(Fe)/1 Mol(Ru), or at least 10.0 Mol(Fe)/1 Mol(Ru), or at least 12.0 Mol(Fe)/1 Mol(Ru), or at least 14.0 Mol(Fe)/1 Mol(Ru), or at least 16.0 Mol(Fe)/1 Mol(Ru), or at least 18.0 Mol(Fe)/1 Mol(Ru). The molar ratio is related to moles of iron and moles of ruthenium (Ru and Fe atoms or ions), not to moles of any compound containing iron or ruthenium. There is no upper limitation of the molar excess of iron to ruthenium, as long as other properties of the bath are not negatively influenced, and preferably as long as Fe is at least mainly in dissolved state. For example, the molar ratio of iron to ruthenium may be as high as 1*10⁹ Mol(Fe)/1 Mol (Ru), or even higher. Such high amount of iron may be chosen also for other reasons, as for example for the brightener stability by using insoluble anodes, for example in horizontal applications/process design. All molar ratios can be combined, in any combination, with any of the ruthenium concentrations indicated in this description.

Preferably iron(II) is mixed in the bath. By addition of iron as indicated above, iron is oxidized from Fe(II) to Fe(III) and ruthenium is reduced to the desired oxidation state Ru(II-III). In this sense, iron has the function of a reducing agent for ruthenium, in addition to other functions that iron may fulfill and that are indicated in this disclosure.

The copper bath contains a copper ion source, for example copper sulfate. Other copper salts can also be used and can at least partially replace copper sulfate as the copper ion source.

An acid is added mainly for increasing the electrical conductivity of the bath. An acid in the sense of the present invention is a compound that leads to the formation of H₃O⁺ ions when added to an aqueous solution. A preferred acid is sulfuric acid. Sulfuric acid can be completely or partially replaced by phosphoric acid, fluoroboric acid, methane sulfonic acid or other acids.

As a further component, the bath of the present invention contains a halide. The halide is preferably chloride. Chloride ions can be added in the form of reagent-grade alkali chlorides (e.g. sodium chloride), or hydrochloric acid. The addition of sodium chloride, if desired, can be omitted completely or partially when halide ions are already contained in other components. If, for example, ruthenium is added to the bath as ruthenium chloride, it is not necessary to add a further chloride salt. In this case ruthenium chloride is both the source of halide ions and the source of ruthenium.

The contents of copper, acid, and optional chloride ions in the bath can be broadly varied. In general, an aqueous solution with the following composition can be used:
Cu²⁺: 4 - 90 g/l, preferably 5 - 80 g/l
copper sulfate (CuSO₄ · 5H₂O): 20 to 360 g/l, preferably 48 to 120 g/l or 160 to 320 g/l;
sulfuric acid: 20 - 350 g/l,
chloride ions: 0.01 to 0.20 g/l, preferably 0.03 to 0.12 g/l.

Copper may for example, and without limitation, be added as CuSO₄ · 5H₂O or copper methane sulfonate (CH₃O₃S)₂Cu The above concentrations of Cu2+ are related to the mass of copper atoms per bath volume, not to the mass of ruthenium compound. When CuSO₄ sulfate is added, the preferable amount of CuSO₄ is 40 - 320 g/l.

The aqueous, acid bath according to the invention also contains at least one brightener compound. In so far as the term "brightener" is used in this description and in the claims, it refers to substances that exert a brightening and accelerating effect during the copper deposition process. These are generally organic compounds, in particular organic compounds containing sulfur, preferably organic thioles, organic sulfides, organic disulfides or organic polysulfides, for example aliphatic thioles, sulfides, disulfides and polysulfides. The brightener compounds may also be organic, e.g., aliphatic, araliphatic or aryl, compounds having a -SH or -S-S- moiety. So that these compounds have sufficient solubility in the aqueous, acid bath, they each preferably contain at least one polar group additionally, for example one or two sulfonic acid groups or respectively salt groups thereof.

In particular, the aqueous, acid bath according to the invention can contain at least one brightener compound that is selected from the group comprising organic thiol compounds, organic sulfide compounds, organic disulfide compounds and organic polysulfide compounds. Most preferred is at least one brightener compound that is selected from the group comprising 3-(benzthiazolyl-2-thio)-propyl sulfonic acid, 3-mercapto-propane-1-sulfonic acid, ethylene dithiodipropyl sulfonic acid, bis-(p-sulfophenyl)-disulfide, bis-(ω-sulfobutyl)-disulfide, bis-(ω-sulfohydroxypropyl)-disulfide, bis-(ω-sulfopropyl)-disulfide, bis-(ω-sulfopropyl)-sulfide, methyl-(ω-sulfopropyl)-disulfide, methyl-(ω-sulfopropyl)-trisulfide, O-ethyl-dithio carbonic acid-S-(ω-sulfopropyl)-ester, thioglycol acid, thiophosphoric acid-O-ethyl-bis-(ω-sulfopropyl)-ester, thiophosphoric acid-tris-(ω-sulfopropyl)-ester and the salts thereof.

The total concentration of all the brightener compounds in the aqueous, acid bath according to the invention is preferably at least 0.01 mg/l, more preferred at least 0.1 mg/l and most preferred at least 1 mg/l. The brightener concentration is preferably not exceeding 100 mg/l in the electrolyte, particularly preferred not exceeding 10 mg/l and most preferred not exceeding 5 mg/l. These values for the lower limit and for the higher limit can be combined together in an arbitrary manner.

The aqueous, acid bath according to the invention can contain additionally at least one carrier substance. In so far as the term "carrier" is used in this description and in the claims, it refers to substances that exert an effect that they suppress (partially) or retard the copper deposition process. These are generally organic compounds, in particular high-molecular compounds that contain oxygen, preferably polyalkylene glycol compounds. These types of compounds can be, for example, high-molecular compounds containing oxygen. These are preferably polyalkylene glycol compounds, for example a polyalkylene glycol or an acid ester, in particular a carboxylic acid ester of a polyalkylene glycol or an ether from a polyalkylene glycol and from one or more alcohols, such as an alkanol ether or a phenol ether of a polyalkylene glycol. These types of additive are for example: polyvinyl alcohol, carboxymethyl cellulose, polyethylene glycol, polypropylene glycol, stearic acid polyglycol ester, oleic acid polyglycol ester, stearic alcohol polyglycol ether, nonylphenol polyglycol ether, octanol polyalkylene glycol ether, octane diol-bis-(polyalkylene glycol ether), poly(ethylene glycol-ran-propylene glycol), poly(ethylene glycol)-block-poly(propylene glycol)- block-poly(ethylene glycol), poly(propylene glycol)- block-poly(ethylene glycol)- block -poly(propylene glycol). The concentration of these compounds is preferably at least approximately 0.005 g/l, particularly preferred at least approximately 0.01 mg/l. The concentration does not exceed approximately 20 g/l, more preferred it does not exceed approximately 5 g/l. These values for the lower limit and for the higher limit can be combined together in an arbitrary manner.

In addition, conventional surfactants or other conventional additives can be contained in the bath.

The aqueous acidic bath of the invention contains at least one source of iron ions as a leveler and/or inhibitor for the deposition of copper. The term "leveler" was defined above. The addition of iron ions results in less copper deposition on the surface that surrounds the structures that are to be filled with copper. The surface surrounding a structure is the surface adjacent to the structure that is to be filled, e.g. the surface on a printed circuit board or wafer which is adjacent to a trench, BMV or through via (not the surface of the structure itself). The term "inhibitor" means the effect that copper deposition on adjacent surfaces, as defined above, is reduced, which is a highly desired effect since copper deposition shall be focused on the structures to be filled.

It has been shown that by addition of iron ions the leveling, inhibiting (inhibition of copper on surfaces adjacent to structures)and filling properties of the bath can even be improved. In combination with ruthenium, a synergistic effect can be observed in comparison to only ruthenium addition or only iron addition. The concentration of iron may be chosen in following preferable lower limits: at least 0.1 mg/l, or at least 0.001 g/l, or at least 0.01 g/l, or at least 0.1 g/l, or at least 0.5 g/l, or at least 1 g/l, or at least 2 g/l, or at least 3 g/l, or at least 5 g/l. A preferable upper limit, than can be combined with every lower limit, as previously mentioned, is 50 g/l, or 30 g/l, or 20 g/l. A preferable range of iron-concentration is 0.1 mg/l - 50 g/l, or 0.001 g/l - 50 g/l, or 0.01 g/l - 50 g/l, or 0.1 g/l - 50 g/l, or 0.5 g/l - 50 g/l, or 1 g/l - 50 g/l, or 2 g/l - 50 g/l, or 3 g/l - 50 g/l, or 5 g/l - 50 g/l. Another preferable ranges are 0.1 mg/l - 30 g/l, or 0.001 g/l - 30 g/l, or 0.01 g/l - 30 g/l, or 0.1 g/l - 30 g/l, or 0.5 g/l - 30 g/l, or 1 g/l - 30 g/l, or 2 g/l - 30 g/l, or 3 g/l - 30 g/l, or 5 g/l - 30 g/l. Still another preferable ranges are 0.1 mg/l - 20 g/l, or 0.001 g/l - 20 g/l, or 0.01 g/l - 20 g/l, or 0.1 g/l - 20 g/l, or 0.5 g/l - 20 g/l, or 1 g/l - 20 g/l, or 2 g/l - 20 g/l, or 3 g/l - 20 g/l, or 5 g/l - 20 g/l. The most preferable range is 5 g/l - 20 g/l and best results are obtained in this concentration range. The concentrations are related to the mass of iron atoms per bath volume, not on the mass of an iron compound. Preferably Fe(II) or Fe(III) is mixed in the bath, most preferably Fe(II). After a short operating time, an equilibrium arises of the Fe(II) and Fe(III) in the bath. Other preferable amounts of iron in the bath can be calculated according to any preferable molar ratio of iron to ruthenium, as indicated above, when ruthenium is added in a preferable amount, as also indicated above. For example, if ruthenium concentration is chosen as 0.01 mg/l and the molar ratio is chosen as at least 18.0 Mol(Fe)/1 Mol(Ru), the iron concentration is at least about 0.1 mg/l. Such exemplary minimum concentration can be combined with any of the preferable upper limits indicated above, such as 50 g/l. In this example, iron concentration is preferably 0.1 mg/l - 50 g/l, more preferable 0.1 mg/l - 30 g/l, most preferably 0.1 mg/l - 20 g/l. All iron concentrations can be combined in any combination with any of the ruthenium concentrations indicated in this description, provided that the molar ratio according to claim 1 is respected. The source of iron ions is preferably a water soluble iron salt, for example an acetate, carbonate, acetates, chloride, bromide, carbonate, fluoride, sulfate, tetrafluorborate, phosphate, perchlorate, citrates, fumarate, gluconate, methansulfonate or oxalate of iron(II) or iron(III).

The present invention also relates to a process for electrolytic deposition of copper on a work piece, the process comprising
a) providing an aqueous acidic bath as described above as well as at least one anode
b) contacting the work piece and the at least one anode with the aqueous acidic bath,
c) providing an electric current flow between the work piece and the at least one anode, so that copper is deposited on the work piece.

The process is preferably used for filling structures, such as blind micro vias, trenches, or through hole vias with copper. The term "filling" means that said structures are filled at least until the edge between a side wall of said structure and the surface of a workpiece. In this embodiment step c) is performed until said structure is filled. It has been shown that by the process of the invention an accurate filling of said structures can be reached. BMVs do not have a so-called dimple shape.

The process is especially beneficial for filling of through hole vias. Moreover, the process is very suitable for copper plating.

The process of the invention, including all other processes described in this disclosure, is particularly
- a process for uniform deposition of copper in structures, particularly in blind-micro-vias (BMVs), through holes and trenches, and/or
- a process for reducing the time of copper deposition, and/or
- a process for inhibiting deposition of copper on the surface that surrounds a structure that is to be filled with copper.

In this regard it is referred to the leveling, promoting and/or inhibiting function of ruthenium and the bath of the invention, as defined and explained above.

WO2006032346 discloses a filling process for through holes which is performed in two steps, as explained in the introductory part of this application, and the use of different acidic baths and process parameters is suggested. In the process of the present invention, however, filling of through hole vias can be reached in one step only, using only one acidic bath and only one set of process parameters. Thereby, very acceptable or even excellent metallization results can be obtained. Moreover, filling of through holes can be reached without inclusions. The process is especially suitable for through holes with a diameter of 50 to 1000 µm, through silicon vias (TSV) with a diameter of 1-100 µm, and for holes, including the afore mentioned holes and vias, with an aspect ratio (hole depth/ hole diameter) of 0.5 : 1 - 1 : 30 and 1 : 30 to 30:1, wherein specific examples are (µm depth/ µm diameter) 40/100, 100/100, 200/100, 100/80, 400/100, 1000/300, 1000/500, and 1000/1000.

According to another embodiment the process of the invention is used for deposition of copper within a through hole via, wherein in the process the through hole via is divided by a copper deposition and two blind holes are formed. In other words the through hole via is divided into two blind holes by a copper deposition. The copper deposition extends transverse to the wall or the walls of the through hole via. A blind hole means a hole that does not go all the way through the board. Such blind holes may also be called blind micro vias according to the definition as given above. In the process, expressed in other words, a copper deposition is formed within the through hole that extends transverse to the wall or the walls of the though hole via, so that the through hole via is divided by the copper deposition into two blind holes.

In this embodiment step c) is performed until two blind holes have been formed. Copper deposition starts on the surface of the wall and the deposition expands, or extends, during the process towards the center of the hole. A continuous copper connection is formed when copper depositions, that raise from different directions towards the center of the hole, meet in the center of the hole. Thereby, a continous copper deposition is formed that divides the hole into two blind holes. The copper deposition forms the bottom wall of the two blind holes.

This embodiment of the process is also called "partial filling" of through-hole vias with copper. It has been shown in the present invention that two blind holes can be formed in shorter times with a bath of the invention than with a bath not containing any ruthenium. Because of this benefit the acidic bath of the invention and the process according to this embodiment is particularly suitable for through-hole-vias with relatively large diameter, e.g. a diameter of more than 500 µm, especially 500 - 1000 µm.

In the aforementioned embodiment, a through hole via is only partially filled and two blind holes are formed which are accessible from opposing surfaces of the workpiece. A through hole via extends between two opposing surfaces of a work peace and the term "within a through hole via" means a location in the through hole via between the opposing surfaces of a work piece, or, otherwise expressed: a location between the two ends of the through hole via.

In this embodiment, the through hole is closed at a location somewhere between the two ends of the through hole. Deposition of copper preferably occurs mainly in the center or near to the center of the through hole. This means that deposition preferably occurs mainly on half of the distance between the two ends of the through hole. Thereby, two blind holes are formed that have the same or nearly the same depth.

When the process in this embodiment has ended, i.e. when two blind holes have been formed, the two blind holes can be further filled by any known filling process which uses for example the same or a different electrolyte and other process parameters. Examples for filling BMVs in a next step are given in WO2006032346. It is, however, preferred to just continue the process with the acidic bath of the invention and the same process parameters until also the two intermediate blind holes are filled which means that in result the through hole is filled.

Preferred parameters of the process of the invention are described below.

To produce the bath of the invention, an aqueous solution of copper ions, an acid, and preferably also chloride, can be prepared, which is also called the "basic composition". The additional substances and other additives are added to the basic composition. The operating conditions of the bath are preferably as follows:
pH value: 0 to <3;
temperature: 15 °C - 60°C, particularly preferred 15°C - 50°C
average cathodic current density: 0.5 - 20 A/dm², preferably 0.5 - 12 A/dm², particularly preferred 0.7 - 10 A/dm².

The deposition bath can be moved in particular by a strong inflow and, where applicable, by clean air being blown in, such that the surface of the bath undergoes strong movement. This means that the substance transport is maximized in the vicinity of the cathodes and anodes so that a greater current density is made possible. Electrolyte flow can also be improved by pump performance (flow, pressure) as well as by flow characteristics (spray nuzzles, draining management). Movement of the cathodes also improves the material transport at the respective surfaces. In addition, convection can also be produced in the bath by rotating the work piece, for example a semiconductor wafer, at a relatively high speed in the bath so that there is a pull of the liquid towards its surface. Constant diffusion-controlled deposition is achieved by means of the increased convection and electrode movement. The work piece can be moved in a horizontal and vertical manner and/or by means of vibration. A combination with the air blown into the deposition bath is particularly effective.

Different types of anodes can be used and there is no special limitation in the process. One type of anodes is copper anodes. In this case the copper consumed during the deposition process can be supplemented electrochemically via the copper anodes. They can be suspended directly in the electrolyte, for example in the form of bars or plates, or they can be used in the form of balls or pellets and be filled into titanium baskets located in the bath for this purpose.

Another type of anodes is insoluble anodes. These types of anodes are inert during the depositing process and consequently do not change their shape. This enables a time- constant geometry during the depositing process. In particular precious metals, such as platinum or also so-called valve metals such as titanium, coated with mixed oxides of precious metals, for example with a coating of ruthenium oxide and iridium oxide, can be used as insoluble anodes. The insoluble anodes can be in the form of expanded metal. In order to obtain a supplement of copper ions when using insoluble anodes, a copper compound can be dissolved in the bath, or metallic copper is brought into contact with the aqueous, acid copper bath according to the invention. This metal dissolves under the action of oxygen dissolved in the bath or with the help of compounds that form the oxidised form of a redox system, for example with the help of Fe(III)-ions dissolved in the bath which are thereby reduced to Fe(II)-ions. The Fe(II)-ions are oxidised at the insoluble anode back to Fe(III)-ions. The Fe(II)/Fe(III)-ions can originate, for example, from the corresponding iron sulfate salt. Preferred concentrations of iron were given above. If iron ions are used together with insoluble anodes, iron ions fulfill two properties: they fulfill the property as a leveler and/or inhibitor for copper deposition, as already mentioned above, and they serve as a redox system.

In the present invention it has been found out that ruthenium salts, e.g. Ru(II) and Ru(III) do not perform as a redox system in this sense. Ru ions also do not work as a redox system if used in the preferred concentration of 0.5 mg/l - 100 mg/l. It has also been shown that Ru does not fulfill the properties of a redox system as indicated in WO9826114. An object of WO9826114 was to deposit copper layers with uniform thickness as possible at all sites of the coated surface and to manufacture layers that are approximately for example 25 µm both on the outside and in drilled holes of printed circuit boards that can endure multiple immersions in a solder bath without cracking. Experiments of the present inventors have shown that addition of Ru to an aqueous acidic bath for the deposition of copper does not lead to equally thick layers, e.g. 25 µm, both on the outside and in drilled holes of printed circuit boards, as taught by WO9826114. When using an acidic solution and a process of the present invention, thicker copper layers are formed in structures like trenches, BMVs and through vias than on a surface surrounding these structures. In other words, copper deposition on the surface, of e.g. a printed circuit board, is minimized, which is a higly desired effect. The thickness of a copper layer on the surface is much thinner than 25 µm. It was found to be in the magnitude of about ≤15 µm.

The object of the present invention was different than the object of WO9826114. The object of the present invention was to reach a uniform, void free and/or dimple-free filling of structures as through holes, trenches and BMVs with copper, not to coat a surface, both on the outside and inside of drilled holes, with a copper layer with uniform thickness. In the present invention it has been shown that the above-mentioned effects can be reached by addition of ruthenium and iron in a molar ratio according to claim 1, which serves as promoter for copper deposition and reduces copper deposition on surfaces on the outside of structures that are filled.

Copper can be deposited both in the conventional manner, by immersing the work piece into a deposition bath that is located in an immersion bath container and polarising the work piece in relation to an anode that is located in the same bath, and also by a horizontal depositing method. The latter depositing methods are carried out in conveyorized horizontal apparatus, through which the work pieces are conveyed in the horizontal position and direction of transport, at the same time being brought into contact with the deposition bath. The anodes are also disposed in a horizontal position in the apparatus along the transport path for the work pieces. These types of apparatus are disclosed, for example, in DE 36 24 481 A1 and DE 32 36 545 A1. In addition, semiconductor wafers are preferably treated in so-called cup-platers, in which a respective wafer is disposed in the horizontal position above an anode that is also disposed in the horizontal position. The cup-plater is filled with the deposition bath. Consequently, both the wafer and the anode are in contact with the deposition bath. The wafer rotates during the depositing process.

In the process of the invention the work piece and at least one anode are connected to a current or respectively voltage source. The electric current flow between the work piece and the at least one anode can be a direct current. In place of a direct current (DC) method, the coppering can also be carried out using a pulsed current or pulsed-voltage plating process. In the pulsed-current process, the current is set galvanostatically between the workpieces that are polarized as cathodes (such as printed circuit boards) and the anodes and modulated by suitable means. The voltage between the cathodes and anodes occurs automatically. In the pulsed-voltage process, a voltage is set potentiostatically between the workpieces and the anodes and modulated over time to produce a voltage that can be modulated over time. In this case, the current arises automatically.

Pulsed current methods include unipolar pulsed current methods, where the depositing current is regularly interrupted and there are pauses in the current between the depositing pulses, and reverse pulse plating, where the current is reversed at times at the work piece during the plating process, i.e., switched anodically. The anodic pulses should be at least as strong as the cathodic pulses. The anodic pulses are preferably two-to-three times stronger than the cathodic current pulses. Overall, the charge that flows during the (cathodic) deposition phase should be much larger than the charge in the anodic phase. The reverse pulse plating method was developed for the electrolytic deposition in particular of copper on circuit boards with a high aspect ratio and is described, for example, in DE 42 25 961 C2 and DE 27 39 427 A1. Where higher current densities are used, improved surface distribution and throwing power is achieved in the through holes.

Exemplary parameters of a reverse pulse plating process are as follows:
The ratio of the duration of an at least one forward current pulse to the duration of an at least one reverse current pulse is adjusted to at least 5, preferably to at least 15. This ratio can be adjusted to 75 at most and preferably to 50 at most. It is particularly preferred to adjust this ratio to 16 - about 20.

The duration of an at least one forward current pulse can be adjusted to preferably at least 5 ms to 250 ms.

The duration of an at least one reverse current pulse is preferably adjusted to 50 ms at most and most preferably to 0.1 - 20 ms.

The current average is adjusted to a value of 0.01 - 20 A/dm², more preferably 2.5 - 8 A/dm².

The peak current density of the at least one reverse current pulse at the work piece will preferably be adjusted to a value of 80 A/dm² at most. Particularly preferred is a peak current density of the at least one reverse current pulse at the workpiece of about 30 - 60 A/dm² in horizontal processes. In vertical processes the most preferred peak current density of the at least one forward current pulse at the workpiece is 3 - 10 A/dm² at most.

In one embodiment of the process the work piece is treated with a pretreatment-solution for a pretreatment of the surface of the work piece before copper is deposited on the surface, wherein the pretreatment solution comprises one or more substances that are selected from copper ions, an acid, a brightener compound, a leveler compound (leveler other than ruthenium), halide ions, and ruthenium. With respect to ruthenium it is also referred to the above disclosure with respect to ruthenium. Examples of leveler compounds other than ruthenium are Inpulse H5, Cuprapulse XP7 and Cuprapulse S4, products from Atotech.

In this embodiment, the process for electrolytic deposition of copper on a work piece comprises
a) pre-treating the work piece with a pretreatment-solution as defined above,
b) providing an aqueous acidic bath of the invention, as described above, as well as at least one anode
c) contacting the work piece and the at least one anode with the aqueous acidic bath,
d) providing an electric current flow between the work piece and the at least one anode, so that copper is deposited on the work piece.

The pretreatment-solution preferably comprises ruthenium and one or more substances that are selected from copper ions, an acid, a brightener compound, a leveler compound, and halide ions. In a special embodiment, the pretreatment-solution comprises ruthenium and at least a brightener compound. In another special embodiment, the pretreatment-solution comprises ruthenium and at least a leveler compound.

If the pretreatment-solution comprises one or more brightener compounds, the total concentration of all brightener compounds in the pretreatment-solution is preferably at least 0.1 mg/l, more preferred at least 10 mg/l and most preferred at least 100 mg/l. In contrast to the preferred concentration of brightener compounds in the aqueous acidic bath, the brightener concentration in the pretreatment-solution may in a preferred embodiment be ≥100 mg/l.

The present invention is in a further aspect directed to the use of the aqueous acidic bath as described in this disclosure for partial or complete filling of through-hole vias with copper. The present invention is moreover directed to the use of the aqueous acidic bath as described in this disclosure for copper deposition in blind micro vias or trenches. The use of the aqueous acidic bath is particularly directed to obtaining one or more of the special and beneficial effects as described in this disclosure, as for example the described leveling effect, promoting effect etc.

The following examples and comparative examples are used to explain the invention. Ruthenium, if added, was added as Ru(3.5)chloride salt, wherein "3.5" is an average oxidation number of ruthenium ions of the salt.

### Comparative example 1 (partial through hole filling)

### Experimental set up: laboratory scale

The through hole vias to be filled had a diameter of 200 µm and a depth of 400 µm.

**electrolyte**

| | |
|---|---|
| Cu (aded as CuO) | 50 g/l |
| sulphuric acid | 200 g/l |
| chloride | 40-45 mg/l |
| Brightener (Cuprapulse S3, Atotech) | 1 ml/l |
| Leveller (Cuprapulse S4, Atotech) | 18 ml/l |

**process parameter**

| | |
|---|---|
| temperature | 20 °C |
| current avarage | 5 Adm⁻² |
| current reverse | 35 Adm⁻² |
| pulse time forward | 80 ms |
| pulse time reverse | 4 ms |
| time | 60 min |

### Comparative example 1a (partial through hole filling)

The same experimental set up and the same process parameters were used as in comparative example 1a, except for the reaction time that was 66 min. 10 mg/l ruthenium were added to the electrolyte of comparative example 1.

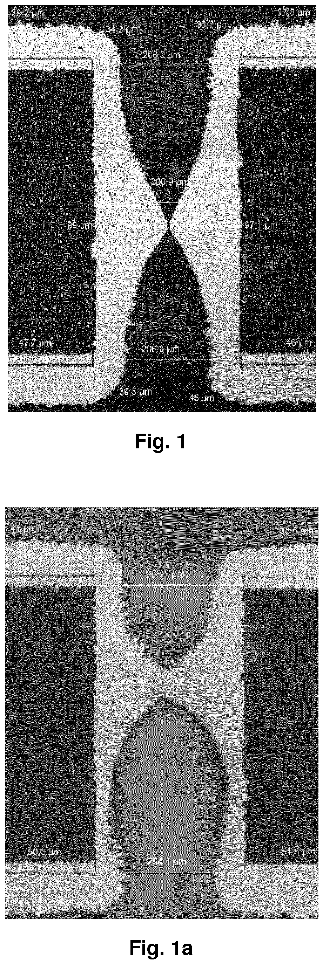

The results of comparative example 1a and example 1 are shown in Fig. 1 (comparative ex.) and Fig 1a. Both through holes are filled partially. It is shown that the through hole via is divided by a relatively thick copper deposition and that two blind micro vias have been formed in example 1a/Fig. 1a, whereas a copper bridge within the hole has not yet been formed in comparative example 1/Fig. 1. Moreover BMVs with a V-shaped bottom are formed in comparative example 1 /Fig. 1, whereas BMVs are formed that have a U-shaped bottom in example 1a/Fig. 1a.

### Comparative example 2 (BMV filling)

### Experimental set up: laboratory scale

**electrolyte**

| | |
|---|---|
| Cu (added as Cu sulfate) | 60 g/l |
| sulphuric acid | 80 g/l |
| chloride | 40 mg/l |
| Fe (added as Fe sulfate) | 9 g/l |
| Brightener (Inpulse, Atotech) | 5 ml/l |
| Leveller (Inpulse H5, Atotech) | 5 ml/l |

**process parameter**

| | |
|---|---|
| temperature | 30-35 °C |
| current avarage | 5 Adm⁻² |
| current reverse | 50 Adm⁻² |
| pulse time forward | 80 ms |
| pulse time reverse | 4 ms |
| time | 70 min |

### Comparative example 2a (BMV filling)

The same experimental set up and the same process parameters were used as in comparative example 2, except that the reaction time was 60 min instead of 70 min. 5 mg/l ruthenium were added to the electrolyte of comparative example 2.

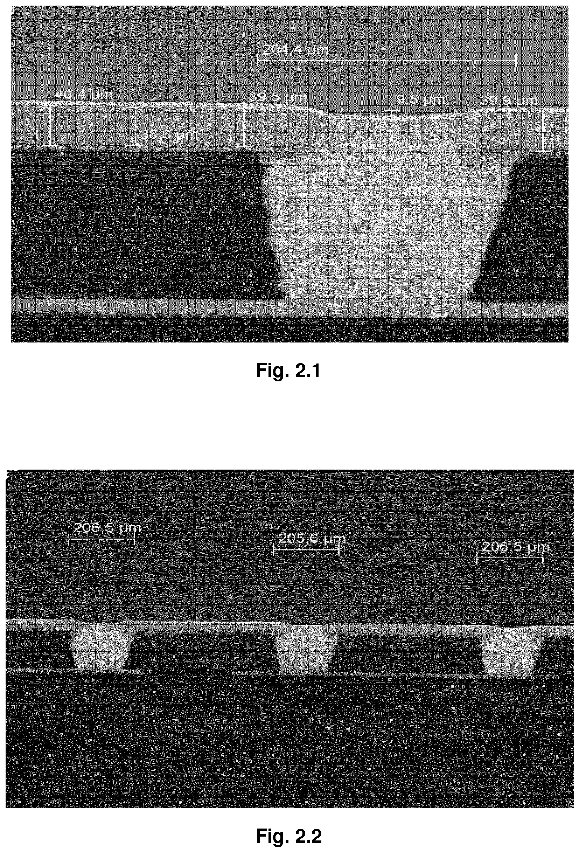

The results of comparative example 2 are shown in Fig. 2.1 and 2.2 (comparative ex.) in a different scaling. Fig. 2.2 shows that the selected BMV structure of Fig. 2.1 can also be observed in other BMVs.

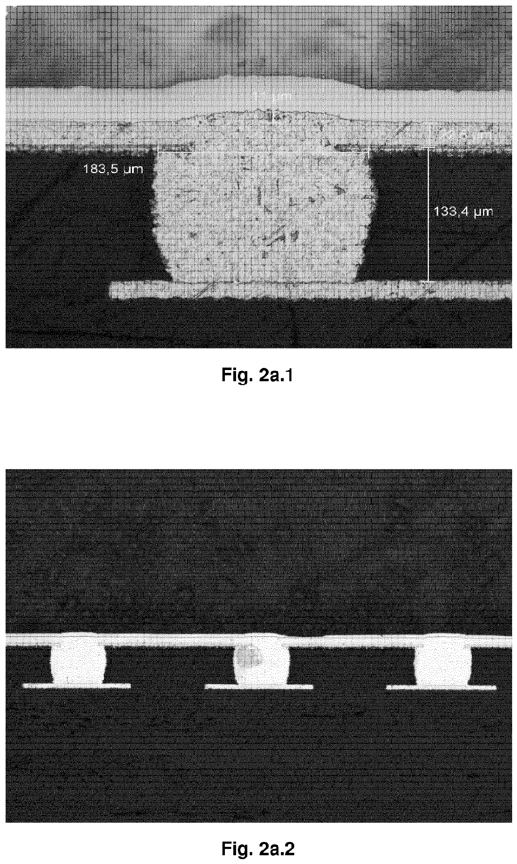

The results of example 2a are shown in Fig 2a.1 and 2a.2 in a different scaling. Fig. 2a.2 shows that the selected BMV structure of Fig. 2a.1 can also be observed in other BMVs. The structure in the comparative example shows a slight dimple. It is shown that the filling of the BMV is better when ruthenium is added: The filling is uniform and no dimple is observed. In Fig. 2.1 (Fe only) a slight dimple is observed, whereas in Fig. 2a.1 the BMV is even overfilled, in a way that Cu filling reaches beyond the surface surrounding the BMV. Moreover, the process time could be reduced, with less Cu-surface thickness than without ruthenium.

### Comparative example 3 (BMV filling)

### Experimental set up: laboratory scale

**electrolyte**

| | |
|---|---|
| Cu (added as Cu sulfate) | 60 g/l |
| sulphuric acid | 80 g/l |
| chloride | 40 mg/l |
| Fe (added as Fe sulfate) | 9 g/l |
| Brightener (Inpulse, Atotech) | 5 ml/l |
| Leveller (Inpulse H5, Atotech) | 5 ml/l |

**process parameter**

| | |
|---|---|
| temperature | 30-35 °C |
| current avarage | 5 Adm⁻² |
| current reverse | 50 Adm⁻² |
| pulse time forward | 40 ms |
| pulse time reverse | 4 ms |
| time | 30 min |

### Comparative example 3a (BMV filling)

The same experimental set up and the same process parameters were used as in comparative example 3. 5 mg/l ruthenium were added to the electrolyte of comparative example 3.

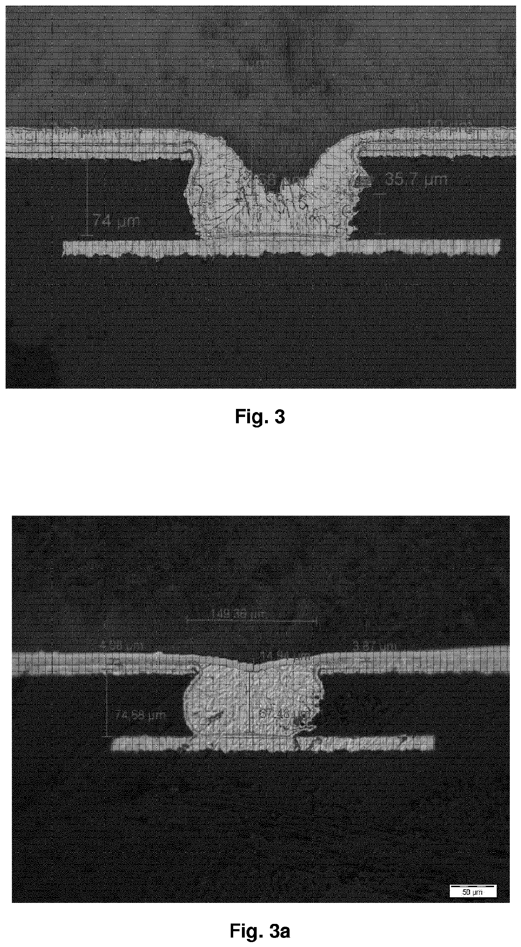

The result of comparative example 3 is shown in Fig. 3. The result of example 3a is shown in Fig. 3a. The structure in the comparative example shows a dimple. It is shown that the filling of the BMV is better when ruthenium is added: The filling is uniform and no dimple is observed. Moreover, the Cu-surface thickness could be reduced in comparison to the comparative example without ruthenium.

### Comparative example 4 (partial through hole filling)

Experimental set up: single board processor, as described in Patent Application Nos WO2004022814, WO2006002969, WO2006000439, WO2008148578, WO2008148579 and WO2008148580. The through hole vias to be filled had a diameter of 500 µm.

**electrolyte**

| | |
|---|---|
| Cu (added as Cu sulfate) | 20 g/l |
| sulphuric acid | 250 g/l |
| chloride | 100 mg/l |
| Fe (added as Fe sulfate) | 9 g/l |
| Brightener (Inpulse, Atotech) | 5 ml/l |
| Leveller (Inpulse H5, Atotech) | 5 ml/l |

**process parameter**

| | |
|---|---|
| temperature | 30-35 °C |
| current avarage | 8 Adm⁻² |
| current reverse | 50 Adm⁻² |
| pulse time forward | 80 ms |
| pulse time reverse | 4 ms |
| time | 30 min |

Comparative example 4a (partial through hole filling)

The same experimental set up and the same process parameters were used as in comparative example 4. In example 4a, 20 mg/l ruthenium were added to the electrolyte of comparative example 4.

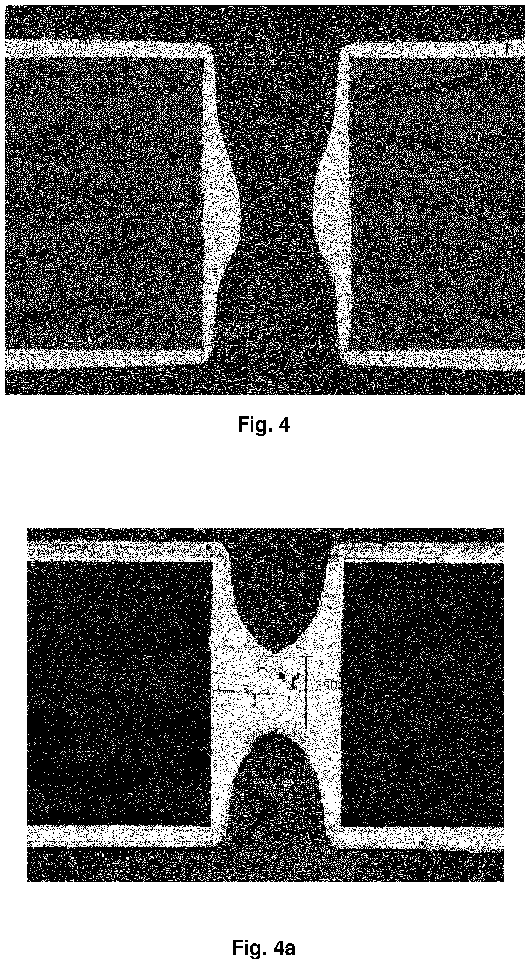

The result of comparative example 4 is shown in Fig. 4. The result of example 4a is shown in Fig. 4a. When comparing comparative example 4 and example 4a it can be seen that addition of ruthenium leads to a formation of two BMVs in shorter time. The bottom of the BMVs, as formed in example 4a, have a U-shape. Less copper is deposited on the surfaces adjacent to the hole in example 4a than in the comparative example 4, and a thinner copper layer is obtained there (shown as horizontal surfaces in Figs. 4, 4a).

### Comparative example 5 (partial through hole filling)

### Experimental set up: Inpulse 2 Plater

The through hole vias to be filled had a diameter of 1000 µm and a depth of 1000 µm.

**electrolyte**

| | | |
|---|---|---|
| Cu (added as Cu sulfate) | 20 | g/l |
| sulphuric acid | 250 | g/l |
| chloride | 110 | mg/l |
| Fe (added as Fe sulfate) | 9 | g/l |
| Brightener (Inpulse, Atotech) | 5 | ml/l |
| Leveller (Inpulse H5, Atotech) | 5 | ml/l |

**process parameter**

| | | |
|---|---|---|
| temperature | 30-35 | °C |
| current avarage | 8 | Adm⁻² |
| current reverse | 50 | Adm⁻² |
| pulse time forward | 80 | ms |
| pulse time reverse | 4 | ms |
| time | 70 | min |

### Example 5a and 5b (partial through hole filling)

A different experimental set up was used in examples 5a and 5b than in comparative example 5: A single board processor was used which is described in detail in patent application Nos WO2004022814, WO2006002969, WO2006000439, WO2008148578, WO2008148579 and WO2008148580.

The process parameters were as follows:

| **electrolyte** | Ex. 5a | | Ex. 5b | |
|---|---|---|---|---|
| Cu (added as Cu sulfate) | 55 | g/l | 20 | g/l |
| sulphuric acid | 120 | g/l | 250 | g/l |
| chloride | 90 | mg/l | 110 | mg/l |
| Fe (added as Fe sulfate) | 9 | g/l | 9 | g/l |
| Brightener | 5 | ml/l | 5 | ml/l |
| Leveller | 5 | ml/l | 5 | ml/l |
| ruthenium | 20 | mg/l | 20 | mg/l |

**process parameter**

| | | | | |
|---|---|---|---|---|
| temperature | 48 | °C | 30-35 | °C |
| current avarage | 8 | Adm⁻² | 8 | Adm⁻² |
| current reverse | 50 | Adm⁻² | 50 | Adm⁻² |
| pulse time forward | 80 | ms | 80 | ms |
| pulse time reverse | 4 | ms | 4 | ms |
| time | 70 | min | 70 | min |

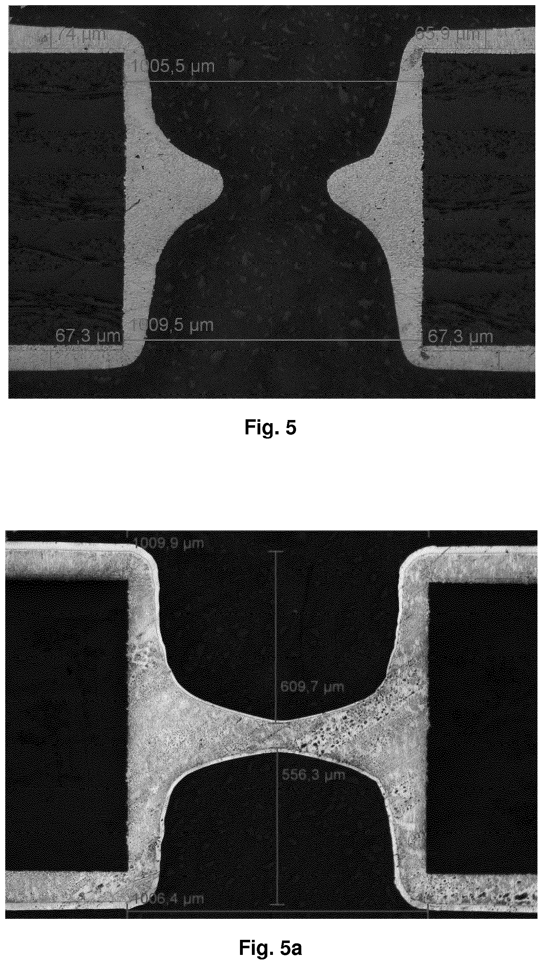

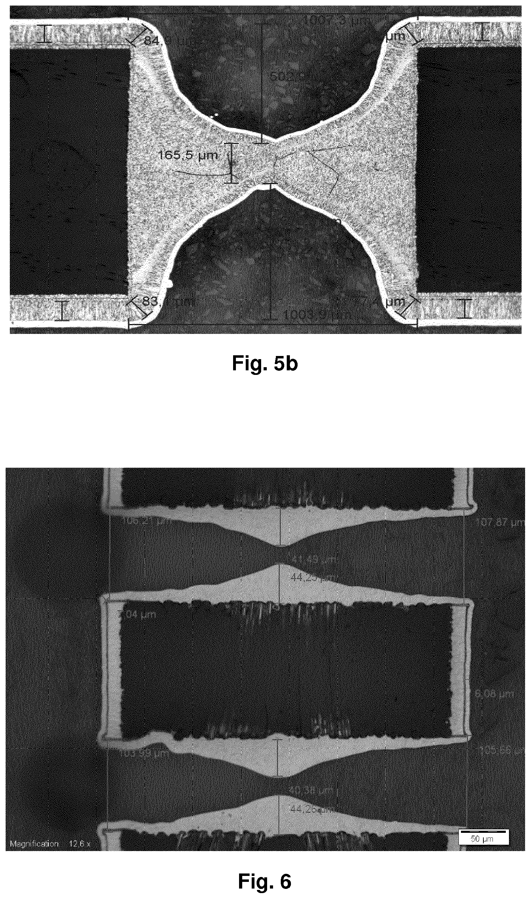

The result of comparative example 5 is shown in Fig. 5. The results of examples 5a and 5b are shown in Fig. 5a and Fig 5b.

The experimental set up, the electrolytes and the process parameters are the same when comparing comparative example 5 with example 5b. In example 5a, parameters are slightly different to the comparative example. When comparing comparative example 5 with example 5b it can be shown that addition of ruthenium leads to a formation of two BMVs in through holes with a large diameter of 1000 µm, whereas in the comparative example 5 no copper-connection in the through hole and thus no BMVs have been formed after the same time.

### Comparative example 6 (partial through hole filling)

Experimental set up: single board processor, as described in Patent Application Nos WO2004022814, WO2006002969, WO2006000439, WO2008148578, WO2008148579 and WO2008148580.

The through hole vias to be filled had a diameter of 100 µm and a depth of 400 µm.

**electrolyte**

| | | |
|---|---|---|
| Cu (added as Cu sulfate) | 24 | g/l |
| sulphuric acid | 250 | g/l |
| chloride | 75 | mg/l |
| Fe (added as Fe sulfate) | 9 | g/l |
| Brightener | 5 | ml/l |
| Leveller | 5 | ml/l |

**process parameter**

| | | |
|---|---|---|
| temperature | 30-35 | °C |
| current avarage | 5 | Adm⁻² |
| current reverse | 50 | Adm⁻² |
| pulse time forward | 80 | ms |
| pulse time reverse | 4 | ms |
| time | 10 | min |

### Example 6a (partial through hole filling)

The same experimental set up and the same process parameters were used as in comparative example 6,. In example 6a, 10 mg/l ruthenium were added to the electrolyte of comparative example 6.

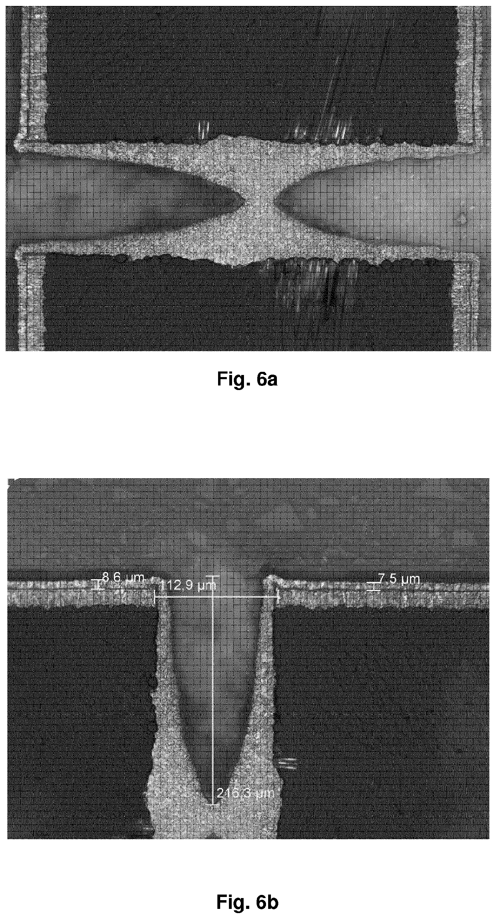

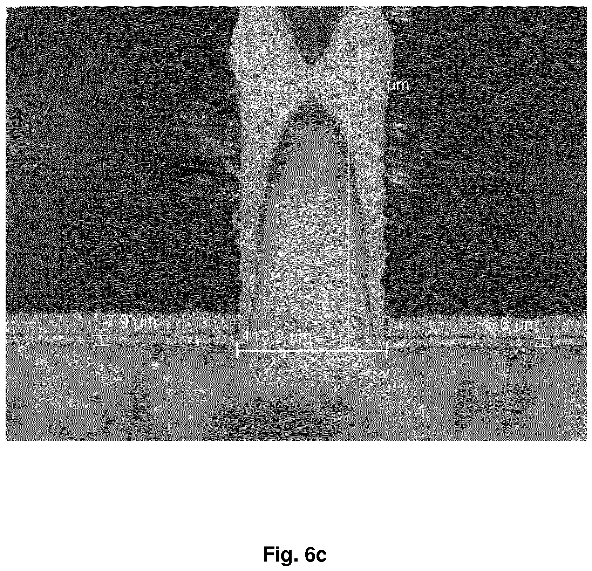

The result of comparative example 6 is shown in Fig. 6. The result of example 6a is shown in Fig. 6a. In the comparative example no copper-connection in the through hole and thus no BMVs have been formed after 10 min, whereas in the examples with ruthenium this has been happened. Fig. 6b and Fig. 6c show details of Fig. 6a in higher magnification and with scales added, wherein Fig. 6b shows the left side of Fig. 6a, turned by 90°, and Fig. 6c shows the right side of Fig. 6a, turned by 90°.

### Comparative example 7 (complete through hole filling)

### Experimental set up: pilot plant with air agitation

The through hole vias to be filled had a diameter of 100 µm and a depth of 500 µm.

**electrolyte**

| | | |
|---|---|---|
| Cu (added as Cu sulfate) | 19 | g/l |
| sulphuric acid | 235 | g/l |
| chloride | 90 | mg/l |
| Fe (added as Fe sulfate) | 9 | g/l |
| Brightener | 5 | ml/l |
| Leveller | 6 | ml/l |

**process parameter**

| | | |
|---|---|---|
| temperature | 30-35 | °C |
| current avarage | 5 | Adm⁻² |
| current reverse | 50 | Adm⁻² |
| pulse time forward | 80 | ms |
| pulse time reverse | 4 | ms |
| time | 60 | min |

### Example 7a (complete through hole filling with only one bath)

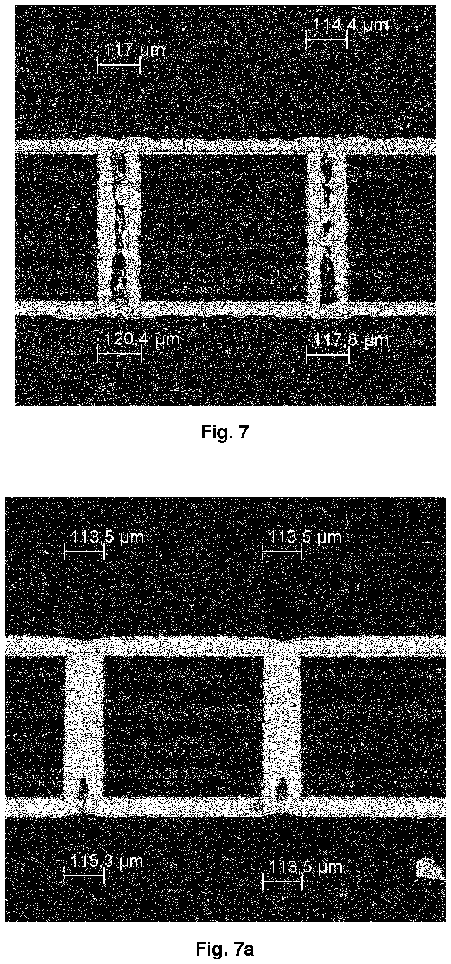

The same experimental set up and the same process parameters were used as in comparative example 7. In example 7a, 20 mg/l ruthenium were added to the electrolyte of comparative example 7. The result of comparative example 7 is shown in Fig. 7. The result of example 7a is shown in Fig. 7a. It can be seen that through hole filling can be done in one step with unchanged parameters and with the same deposition bath when adding ruthenium to the deposition bath. First, a structure of two BMVs is formed, comparable to the structure as shown in Figures 4b and 6a, subsequently the two BMVs are filled, as shown in Fig. 7a. The filling is nearly perfect, only one small inclusion is observed that can likely be avoided by increasing the copper content in the bath. The comparative example, not using ruthenium, shows a worse result. The hole is not filled after a process time of 60 minutes and an irregular, non-uniform deposition is observed.

### Comparative example 8, Example 8a and Example 8b (BMV filling)

### Experimental set up: laboratory scale

**electrolyte**

| | |
|---|---|
| Cu (added as Cu sulfate) | 55 g/l |
| sulphuric acid | 65 g/l |
| chloride | 50 mg/l |
| Brightener (Inpulse, Atotech) | 5 ml/l |
| Leveller (Cuflex 330, Atotech) | 5 ml/l |

**process parameter**

| | |
|---|---|
| temperature | 30 °C |
| current density | 2 Adm⁻² |
| time | 32 min |

In comparative example 8, a so-called virgin make up solution without Fe and without Ru was used. In example 8a, Ru (5 mg/l Ru, added as Ru-chloride) was added, and in ex. 8b, Ru (5 mg/l Ru, as Ru-chloride) and Fe (10 g/l Fe, added as Fe-sulfate) were added. The bath of ex. 8b shows a yellow to green/yellow-color, indicating that Ru is mainly present in oxidation state II-III (average), whereas in example 8a the bath shows a darker brown color, indicating a higher average oxidation state and higher amount of Ru in higher oxidation states, as for example IV and probably higher.

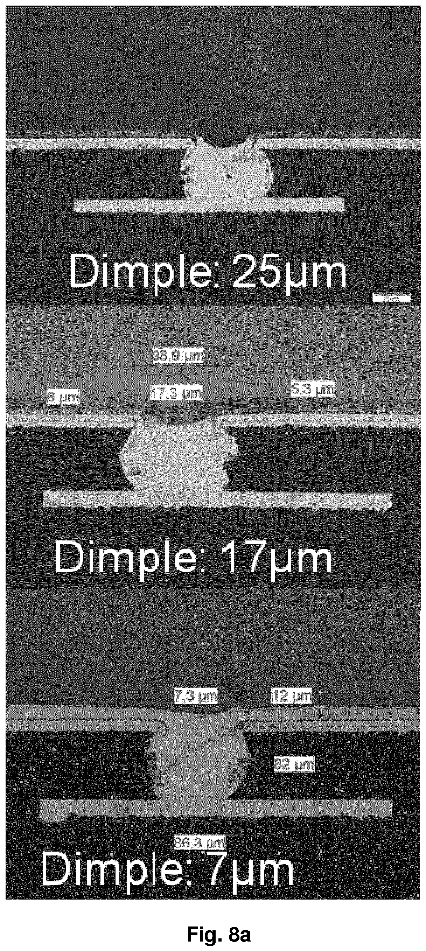

BMVs of different diameter were filled in the comparative example and in the examples:
100 µm diameter, 125 µm diameter, and 150 µm diameter. The same experimental set up and same process parameters were used for all examples and the comparative examples. The recess (dimple) of the plating performance was measured by optical microscopy. The depth of the dimple was measured from an imaginary horizontal line, which is drawn on the same level as the copper deposition surrounding the BMV to the deepest point of the dimple. A vertical scale bar, extending from the deepest point of the dimple to said imaginary horizontal line, indicates the depth (cf. vertical scale bars in dimples in Figs. 8a-8c).

**Fig. 8a shows the results for BMV with 100 µm diameter:**

| | | |
|---|---|---|
| Top: | comparative example 8 | Dimple 25 µm (scale bar: 24.89 µm) |
| Middle: | example 8a, 5 mg/l Ru | Dimple 17 µm (scale bar: 17.3 µm) |
| Bottom: | example 8b, 5 mg/l Ru and 10 g/l Fe | Dimple 7 µm (scale bar: 7.3 µm) |

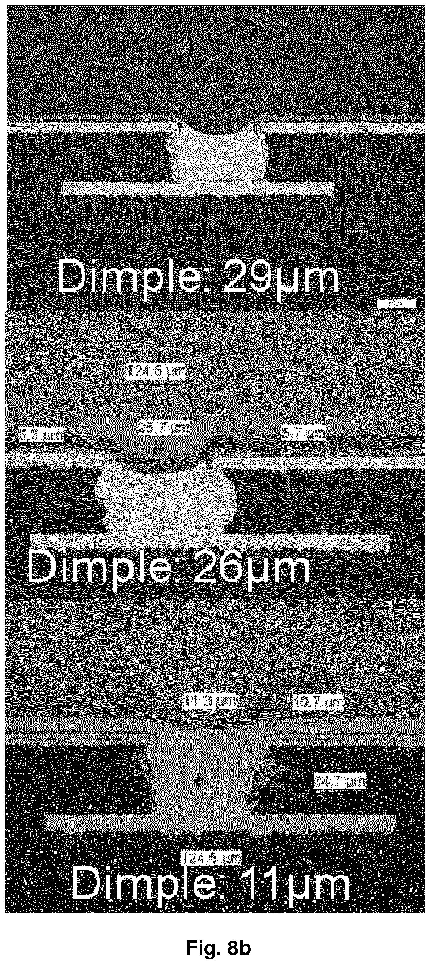

**Fig. 8b shows the results for BMV with 125 µm diameter:**

| | | |
|---|---|---|
| Top: | comparative example 8 | Dimple 29 µm (scale bar 29.0 µm) |
| Middle: | example 8a, 5 mg/l Ru | Dimple 26 µm (scale bar 25.7 µm) |
| Bottom: | example 8b, 5 mg/l Ru and 10 g/l Fe | Dimple 11 µm (scale bar 11.3 µm) |

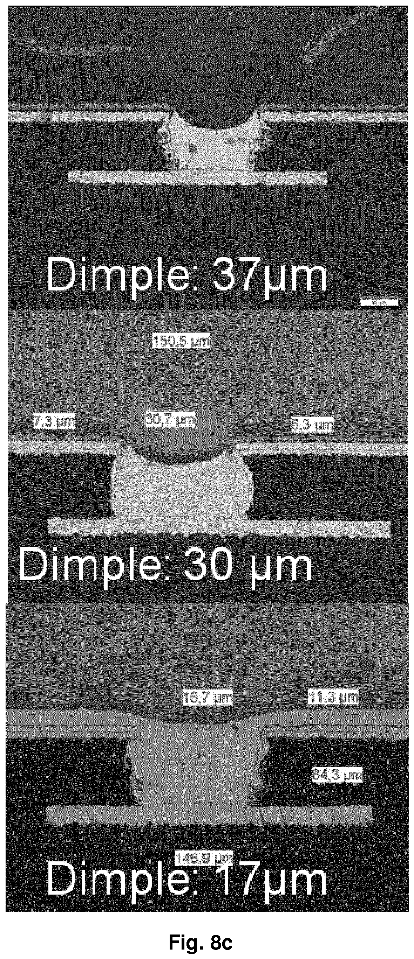

**Fig. 8c shows the results for BMV with 150 µm diameter:**

| | | |
|---|---|---|
| Top: | comparative example 8 | Dimple 37 µm (scale bar 36.78 µm) |
| Middle: | example 8a, 5 mg/l Ru | Dimple 30 µm (scale bar 30.7 µm) |
| Bottom: | example 8b, 5 mg/l Ru and 10 g/l Fe | Dimple 17 µm (scale bar 16.7 µm) |

For all three dimensions of BMV it can be shown that the filling of the BMV is better when Ru is added, and that the filling is even improved when Ru and Fe are added. The results suggest a synergistic effect of Ru and Fe. When Ru and Fe are added, the dimple shows only half of the depth, or even less (Fig. 8a and 8b), in comparison to Ru addition only. A synergistic effect can also be assumed by comparison of this example with comparative example 2/Fig. 2.1 and example 2a/Fig. 2a.1. In comparative example 2/Fig. 2.1 only Fe was added to the bath, and in example 2a/Fig. 2a.1 Fe and Ru were added. In Fig. 2.1 (Fe only) a slight dimple is observed, whereas in Fig. 2a.1 the BMV is even overfilled, in a way that Cu arches beyond the surface surrounding the BMV.

## Claims

1. Aqueous acidic bath for electrolytic deposition of copper, comprising
- at least one source of copper ions,
- at least one acid,
- at least one brightener compound,
- at least one source of halide ions, and
- at least one substance that serves as a leveler for copper-deposition, wherein said at least one substance is dissolved ruthenium, and
- at least one source of iron ions as leveler and/or inhibitor for copper-deposition, **characterized in that**
iron is present in such amount that the molar ratio of iron/ruthenium is at least 1.5 Mol (Fe)/1 Mol (Ru).

2. Aqueous acidic bath according to claim 1, wherein the concentration of ruthenium is 0.01 mg/l - 100 mg/l.

3. Aqueous acidic bath according to claim 1 or 2, wherein the average oxidation state of ruthenium is in the range of II to III.

4. Aqueous acidic bath according to one of claims 1-3, wherein the concentration of iron is 0.1 mg/l - 20 g/l.

5. Use of an aqueous acidic bath as described in one of claims 1-4 for partial or complete filling of through-hole vias with copper.

6. Use of an aqueous acidic bath as described in one of claims 1-4 for copper deposition in blind micro vias or trenches.

7. Process for electrolytic deposition of copper on a work piece, the process comprising
a) providing an aqueous acidic bath as described in one of claims 1-4 as well as at least one anode,
b) contacting the work piece and the at least one anode with the aqueous acidic bath,
c) providing an electric current flow between the work piece and the at least one anode, so that copper is deposited on the work piece.

8. Process according to claim 7, which is a process for filling blind micro vias, trenches, or through hole vias of a work piece.

9. Process according to claim 7 or 8, which is a process for deposition of copper within a through hole via, wherein a copper deposition is formed within the through hole that extends transverse to the wall or the walls of the though hole via, so that the through hole via is divided by the copper deposition and two blind holes are formed.

10. Process according to one of claims 7-9, which is a pulse plating process.

11. Process according to one of claims 7-10, wherein the work piece is treated with a pretreatment-solution for a pretreatment of the surface of the work piece before copper is deposited on the surface, wherein the pretreatment solution comprises one or more substances that are selected from copper ions, an acid, a brightener compound, a leveler compound, halide ions, and ruthenium.

## Patentansprüche

1. Wässriges Säurebad für die elektrolytische Abscheidung von Kupfer, umfassend
- mindestens einer Kupferionenquelle,
- mindestens einer Säure,
- mindestens einer Brightener-Verbindung,
- mindestens einer Halogenidionenquelle und
- mindestens einer Substanz, die als Leveler für die Kupferabscheidung dient, wobei diese mindestens eine Substanz gelöstes Ruthenium ist, und
- mindestens einer Eisenionenquelle als Leveler und/oder Inhibitor für die Kupferabscheidung,
**dadurch gekennzeichnet, dass**
Eisen in solchen Mengen vorhanden ist, dass das Molverhältnis Eisen/Ruthenium mindestens 1,5 Mol (Fe)/1 Mol (Ru) beträgt.

2. Wässriges Säurebad nach Anspruch 1, in dem die Rutheniumkonzentration 0,01 mg/l-100 mg/l beträgt.

3. Wässriges Säurebad nach Anspruch 1 oder 2, wobei die durchschnittliche Oxidationsstufe des Rutheniums zwischen II und III liegt.

4. Wässriges Säurebad nach einem der Ansprüche 1-3, in dem die Eisenkonzentration 0,1 mg/l-20 mg/l beträgt.

5. Verwendung eines wässrigen Säurebads wie in einem der Ansprüche 1-4 beschrieben zum teilweisen oder vollständigen Verfüllen von durchgehenden Vias mit Kupfer.

6. Verwendung eines wässrigen Säurebads wie in einem der Ansprüche 1-4 beschrieben zur Kupferabscheidung in nicht durchgehenden Microvias oder Gräben.

7. Verfahren für die elektrolytische Abscheidung von Kupfer an einem Werkstück, wobei das Verfahren umfasst
a) Bereitstellung eines wässrigen Säurebads wie in einem der Ansprüche 1-4 beschrieben, sowie von mindestens einer Anode,
b) Kontaktierung des Werkstücks und der mindestens einen Anode mit dem wässrigen Säurebad,
c) Bereitstellung eines elektrischen Stromflusses zwischen dem Werkstück und der mindestens einen v Anode, sodass Kupfer an dem Werkstück abgeschieden wird.

8. Verfahren nach Anspruch 7, das ein Verfahrung zur Verfüllung von nicht durchgehenden Microvias, Gräben oder durchgehenden Vias eines Werkstücks ist.

9. Verfahren nach Anspruch 7 oder 8, das ein Verfahren zur Abscheidung von Kupfer innerhalb eines durchgehenden Vias ist, wobei eine Kupferabscheidung innerhalb des Durchgangsloches gebildet wird, die sich quer zur Wand oder den Wänden des durchgehenden Vias ausbreitet, sodass das durchgehende Via von der Kupferabscheidung geteilt wird und sich zwei Sacklöcher bilden.

10. Verfahren nach einem der Ansprüche 7-9, das ein Pulse-Plating-Verfahren darstellt.

11. Verfahren nach einem der Ansprüche 7-10, wobei das Werkstück mit einer Vorbehandlungslösung zur Vorbehandlung der Werkstückoberfläche behandelt wird, bevor Kupfer an der Oberfläche abgeschieden wird, wobei die Vorbehandlungslösung eine oder mehrere Substanzen beinhaltet, die aus Kupferionen, einer Säure, einer Brightener-Verbindung, einem Leveler, Halogenidionen und Ruthenium ausgewählt werden.

## Revendications

1. Bain aqueux acide pour le dépôt électrolytique de cuivre, comprenant
- au moins une source d'ions de cuivre,
- au moins un acide,
- au moins un composé d'azurant optique,
- au moins une source d'ions halogénures, et
- au moins une substance qui sert de niveleur pour le dépôt de cuivre, dans lequel ladite au moins une substance est du ruthénium dissous, et
- au moins une source d'ions de fer en tant que niveleur et/ou qu'inhibiteur pour le dépôt de cuivre,
**caractérisé en ce que**
le fer est présent en une quantité telle que le rapport molaire fer/ruthénium est au moins de 1,5 mole (Fe)/1 mole (Ru).

2. Bain aqueux acide selon la revendication 1, dans lequel la concentration en ruthénium est de 0,01 mg/l à 100 mg/l.

3. Bain aqueux acide selon la revendication 1 ou 2, dans lequel l'état d'oxydation moyen du ruthénium est situé dans la plage allant de II à III.

4. Bain aqueux acide selon l'une des revendications 1 à 3, dans lequel la concentration en fer est de 0,1 mg/l à 20 g/l.

5. Utilisation d'un bain aqueux acide tel que décrit dans l'une des revendications 1 à 4 pour le remplissage partiel ou complet de trous débouchants de liaison avec du cuivre.

6. Utilisation d'un bain aqueux acide tel que décrit dans l'une des revendications 1 à 4 pour le dépôt de cuivre dans des micro-trous de liaison borgnes ou des tranchées.

7. Procédé de dépôt électrolytique de cuivre sur une pièce à travailler, le procédé comprenant
a) la fourniture d'un bain aqueux acide tel que décrit dans l'une des revendications 1 à 4 ainsi qu'au moins une anode,
b) la mise en contact de la pièce à travailler et de l'au moins une anode avec le bain aqueux acide,
c) la fourniture d'un flux de courant électrique entre la pièce à travailler et l'au moins une anode, de sorte que du cuivre se dépose sur la pièce à travailler.

8. Procédé selon la revendication 7, qui est un procédé de remplissage de micro-trous de liaison borgnes, de tranchées, ou de trous débouchants de liaison d'une pièce à travailler.

9. Procédé selon la revendication 7 ou 8, qui est un procédé de dépôt de cuivre à l'intérieur d'un trou débouchant de liaison, dans lequel un dépôt de cuivre est formé à l'intérieur du trou débouchant qui s'étend transversalement par rapport à la paroi ou aux parois du trou débouchant de liaison, de sorte que le trou débouchant de liaison est divisé par le dépôt de cuivre et deux trous borgnes sont formés.

10. Procédé selon l'une des revendications 7 à 9, qui est un procédé d'électrodéposition sous impulsions du courant.

11. Procédé selon l'une des revendications 7 à 10, dans lequel la pièce à travailler est traitée avec une solution de prétraitement pour un prétraitement de la surface de la pièce à travailler avant que du cuivre soit déposé sur la surface, dans lequel la solution de prétraitement comprend une ou plusieurs substances qui sont sélectionnées parmi des ions de cuivre, un acide, un composé d'azurant optique, un composé niveleur, des ions halogénures, et le ruthénium.
